# EUROPEAN PATENT SPECIFICATION

(11) **EP 2 019 487 B1**
(45) Date of publication and mention of the grant of the patent: **01.05.2013**
(21) Application number: 07113380.5
(22) Date of filing: 27.07.2007
(51) Int. Cl.: H03K 17/16, H03M 1/06

(54) **Switching circuitry**
Schaltungsanordnung
Circuit de commutation

(43) Date of publication of application: 28.01.2009
(73) Proprietor: Fujitsu Semiconductor Limited, Kohoku-ku, Yokohama-shi Kanagawa 222-0033 (JP)
(72) Inventor: Walker, Darren, Reading, Berkshire RG4 5EA (GB); Dedic, Ian Juso, Northolt Middlesex UB5 5HW (GB)
(74) Representative: Wilding, Frances Ward

(56) References cited:
- EP-A- 1 720 258
- US-A- 5 933 033
- US-A1- 2002 008 651
- US-B1- 6 344 812

## Description

The present invention relates to switching circuitry for use, for example, in high-speed digital-to-analog converters (DACs).

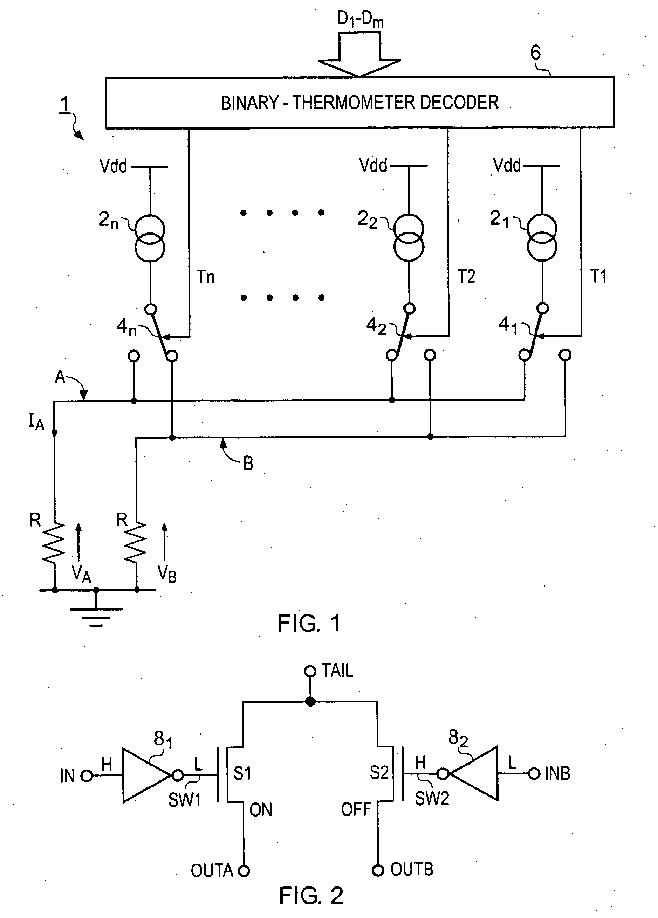

Figure 1 shows an overview of a previously considered DAC. The DAC in Figure 1 is part of a DAC integrated circuit (IC) of the current-steering type, and is designed to convert an m-bit digital input word (D1-Dm) into a corresponding analog output signal.

Referring to Figure 1, the DAC 1 contains analog circuitry including a number n of identical current sources 2₁ to 2ₙ, where n = 2^{m-1}. Each current source 2 passes a substantially constant current I. The analog circuitry further includes a number n of differential switching circuits 4₁ to 4ₙ corresponding respectively to the n current sources 2₁ to 2ₙ. Each differential switching circuit 4 is connected to its corresponding current source 2 and switches the current I produced by the current source either to a first terminal, connected to a first connection line A of the converter, or a second terminal connected to a second connection line B of the converter.

Each differential switching circuit 4 receives one of a plurality of digital control signals T1 to Tn (called "thermometer-coded signals" for reasons explained hereinafter) and selects either its first terminal or its second terminal in accordance with the value of the signal concerned. A first output current I_{A} of the DAC 1 is the sum of the respective currents delivered to the first terminals of the differential switching circuit, and a second output current I_{B} of the DAC 1 is the sum of the respective currents delivered to the second terminals of the differential switching circuit. The analog output signal is the voltage difference V_{A}-V_{B} between a voltage V_{A} produced by sinking the first output current I_{A} of the DAC 1 into a resistance R and a voltage V_{B} produced by sinking the second output current I_{B} of the converter into another resistance R.

The thermometer-coded signals T1 to Tn are derived from the binary input word D1-Dm by digital circuitry including a binary-thermometer decoder 6. The decoder 6 operates as follows. When the binary input word D1-Dm has the lowest value the thermometer-coded signals T1-Tn are such that each of the differential switching circuits 4₁ to 4ₙ selects its second terminal so that all of the current sources 2₁ to 2ₙ are connected to the second connection line B. In this state, V_{A}=0 and V_{B}=nIR. The analog output signal V_{A}-V_{B}=-nIR. As the binary input word D1-Dm increases progressively in value, the thermometer-coded signals T1 to Tn produced by the decoder 6 are such that more of the differential switching circuits select their respective first terminals (starting from the differential switching circuit 4₁) without any differential switching circuit that has already selected its first terminal switching back to its second terminal. When the binary input word D1-Dm has the value i, the first i differential switching circuits 4₁ to 4ᵢ select their respective first terminals, whereas the remaining n-i differential switching circuits 4ᵢ₊₁ to 4ₙ select their respective second terminals. The analog output signal V_{A}-V_{B} is equal to (2i-n)IR.

Thermometer coding is popular in DACs of the current-steering type because, as the binary input word increases, more current sources are switched to the first connection line A without any current source that is already switched to that line A being switched to the other line B. Accordingly, the input/output characteristic of the DAC is monotonic and the glitch impulse resulting from a change of 1 in the input word is small.

An exemplary differential switching circuit suitable for use with the DAC of Figure 1 is shown in Figure 2. This differential switching circuit comprises first and second PMOS field-effect transistors (FETs) S1 and S2. The respective sources of the transistors S1 and S2 are connected to a common node TAIL to which a corresponding current source (2₁ to 2ₙ in Figure 1) is connected. The respective drains of the transistors S1 and S2 are connected to respective first and second output nodes OUTA and OUTB of the circuit which correspond respectively to the first and second terminals of each of the differential switching circuits shown in Figure 1.

Each transistor S1 and S2 has a corresponding driver circuit 8₁ or 8₂ connected to its gate. Complementary input signals IN and INB are applied respectively to the inputs of the driver circuits 8₁ and 8₂. Each driver circuit buffers and inverts its received input signal IN or INB to produce a switching signal SW1 or SW2 for its associated transistor S1 or S2 such that, in the steady-state condition, one of the transistors S1 and S2 is on and the other is off. For example, as indicated in Figure 2, when the input signal IN has the high level (H) and the input signal INB has the low level (L), the switching signal SW1 (gate drive voltage) for the transistor S1 is at the low level L, causing that transistor to be ON, whereas the switching signal SW2 (gate drive voltage) for the transistor S2 is at the high level H, causing that transistor to be OFF. Thus, in this condition, all of the input current flowing into the common node TAIL is passed to the output node OUTA and no current passes to the output node OUTB.

When it is desired to change the state of the circuit of Figure 2 so that the transistor S1 is OFF and the transistor S2 is ON, complementary changes are made simultaneously in the input signals IN and INB such that the input signal IN changes from H to L at the same time as the input signal INB changes from L to H. As a result of these complementary changes the transistor S1 turns OFF and the transistor S2 turns ON, so that all of the input current flowing into the common node TAIL is passed to the output node OUTB and no current passes to the output node OUTA.

One problem with the DAC of Figure 1 is third-order distortion. Third order distortion is particularly undesirable in DACs which produce multi-tone output signals, since third order intermodulation distortion may occur in-band, in which case it cannot be removed by filtering. Such third order distortion is believed to be due in part to currents flowing into and out of parasitic capacitances which are present in the differential switching circuits (Figure 2).

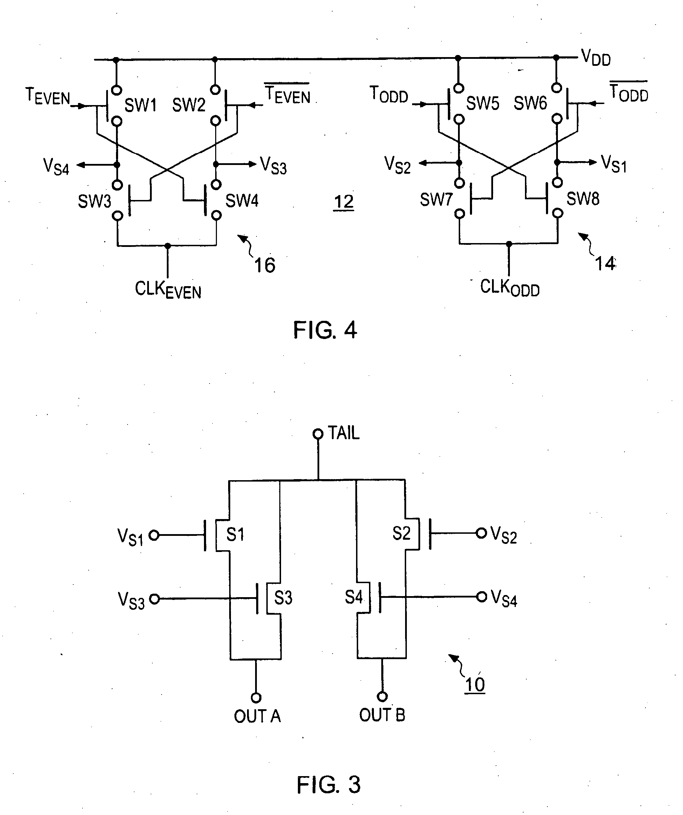

To address this problem, and other problems associated with the DAC of Figures 1 and 2, the present applicants have proposed in EP-A-1720258 a modified differential switching circuit as shown in Figure 3. This differential switching circuit 10 differs from the differential switching circuit of Figure 2 in that it has two FETs associated with each output node OUTA and OUTB. In particular, the first and third FETs S1 and S3 are connected between a first output node OUTA and a common node TAIL. The second and fourth FETs S2 and S4 are connected between a second output node OUTB and the common node TAIL. Each of these four FETs S1 to S4 is turned on or off by a drive signal V_{S1} to V_{S4} applied thereto.

The differential switching circuit 10 of Figure 3 is designed to operate in alternating first and second phases, which may be referred to odd and even phases. The first and second FETs S1 and S2 constitute a first pair of FETs which are available in each odd phase. The third and fourth FETs S3 and S4 constitute a second pair of FETs which are available in each even phase. In each odd phase, one of the FETs of the pair S1 and S2 is turned on and the other of those FETs is turned off. Both transistors of the second pair (S3 and S4) are off. In each even phase, one FET of the pair S3 and S4 is turned on and the other is turned off. The two FETs of the first pair S1 and S2 are both off. The FET which is turned on in a pair is determined by the data applied to the DAC, as will be explained later.

The advantage of the Figure 3 differential switching circuit 10 is that at the start of each odd or even phase the same number of FETs change state. One FET will always be turning on and another FET will always be turning off. For example, consider the case in which S1 is on in an odd phase and then in the next even phase the data remains unchanged. In that case, at the start of the even phase concerned, S1 turns off and S3 turns on, S2 and S4 remaining off. In the Figure 2 differential switch circuit, this is not possible, the switch S1 simply remaining on in successive cycles when the data is unchanged. This means that in the Figure 2 circuit, the number of FETs that change state from one cycle to the next is dependent on the data. In the Figure 3 circuit, on the other hand, the number of FETs that change state from one phase to the next is independent of the data. By arranging the same number of FETs to change state in each phase, the charge which flows into and out of the parasitic capacitances in the circuitry is less dependent on the input data signal. This helps to reduce third order distortion which may occur in the analog output signal.

There are other advantages associated with the Figure 3 circuitry, too. In particular, by arranging the same number of FETs to change state in each phase, the current drawn by each analog segment is approximately the same in each phase. This should help to reduce variations in the timings of the switching operations of the different analog segments, which again may lead to reduced distortion.

Another problem which exists in the DAC of Figures 1 and 2 is timing mis-matches between different analog segments and between different switching parts of the same segment. For example, in the Figure 2 circuit problems will arise if the signals IN and INB applied to one analog segment change at times different from the corresponding signals in other analog segments. Furthermore, even if it could be ensured that there is no timing variation between the IN and INB signals of different analog segments, a problem still arises if the two different switch drivers 8₁ and 8₂ have timing mismatches between them. Such timing mismatches can arise, for example, due to random threshold voltage variations between FETs used to implement the drivers 8₁ and 8₂. The phenomenon of random threshold variation becomes more significant as the transistor sizes are reduced in order to improve the switching speeds of the transistors.

To address the timing mismatch problem, the present applicant has proposed in EP-A-1720258 modified switch driver circuitry as shown in Figure 4. This modified switch driver circuitry 12 is connected to the differential switch circuit 10 of Figure 3, and supplies the drive signals V_{S1} to V_{S4} FETs S1 to S4 in the differential switching circuit 10.

The Figure 3 switch driver circuitry comprises first and second circuits 14 and 16. Each circuit has a clock input node at which one of a pair of complementary clock signals CLK_{ODD} and CLK_{EVEN} is received. Each circuit 14 and 16 also has first and second output nodes. These two output nodes are connected respectively to the gates of the two FETs of a pair of FETs in Figure 3. For example, in the case of the first circuit 14, the first output node is connected to the gate of S1 of the first pair of FETs and the second output node is connected to the gate of S2 in the first pair. The first output node of the second circuit 16 is connected to the gate of S3 in the second pair of FETs S3 and S4, and the second output node of the second circuit 16 is connected to the gate of S4. Each of the first and second circuits 14 and 16 comprises a switch SW8/SW4 connected between the clock input node and the first output node, and a switch SW7/SW3 connected between the clock input node and the second output node.

Each of the first and second circuits 14 and 16 also has a pair of data input nodes at which respective complementary thermometer-coded data signals are received. In the case of the first circuit 14 the complementary data signals are the signals T_{ODD} and T̅_{ODD}. In the case of the second circuit 16 the complementary data signals are the signals T_{EVEN} and T̅_{EVEN}. The complementary data signals T_{ODD} and T̅_{ODD} for the first circuit 14 are generated by a first decoder of the DAC. The complementary data signals T_{EVEN} and T̅_{EVEN} for the second circuit 16 are generated by a second decoder, separate from the first decoder. Each of these decoders carries out a binary-thermometer decoding operation. The frequency of the decoding operations performed by each decoder need only be half the frequency of the conversion cycles of the DAC. This can be useful for reducing power consumption of the decoding circuitry. It may also be useful where the DAC conversion frequency is so high that carrying out decoding operations at the DAC conversion frequency using a single decoder is problematic.

Each of the first and second circuits 14 and 16 further comprises a switch SW6/SW2 connected between the first output node and a positive supply line V_{DD}, and a switch SW5/SW1 connected between the second output node and V_{DD}. The switches SW6 and SW7 in the first circuit 14 are both controlled by the inverted data signal T̅_{ODD}. The switches SW5 and SW8 in the first circuit 14 are both controlled by the data signal T_{ODD}. The switches SW2 and SW3 in the second circuit 16 are both controlled by the inverted data signal T̅_{EVEN}. The switches SW1 and SW4 in the second circuit 16 are both controlled by the data signal T_{EVEN}.

In operation of the Figure 4 switch driver circuitry, the clock signal CLK_{ODD} is active (low) and the clock signal CLK_{EVEN} is inactive (high) in each odd phase. The clock signals CLK_{ODD} and CLK_{EVEN} are inactive (high) and active (low) in each even-numbered phase. Any changes to the data signals applied to either circuit 14 and 16 are made when the clock signal applied to the clock node of the circuit concerned is in the inactive (high) state. In other words, any change in the data signals T_{ODD} and T̅_{ODD} are made only in even phases when CLK_{ODD} is inactive (high). Similarly, any changes in the data signals T_{EVEN} and T̅_{EVEN} are made only in odd phases, i.e. when CLK_{EVEN} is inactive (high).

When the clock signal applied to the first or second circuit is inactive (high) any changes in the data signals applied to the circuit concerned have no effect on the output node potentials. For example, consider the case of the first circuit 14 when a change is made to the data signals during an even phase. Assume that initially SW5 and SW8 are on and SW6 and SW7 are off. The drive signal V_{S1} at the first output node will be equal to the high potential of CLK_{ODD} (this potential is deliberately made to be the same as V_{DD}). The drive signal V_{S2} at the second output node will be V_{DD}. In this condition, S1 and S2 in Figure 3 are both off. If the data signals are now changed, SW5 and SW8 turn off and SW6 and SW7 turn on. The drive signals V_{S1} and V_{S2} remain substantially unchanged (VDD and the high potential of CLK_{ODD} respectively).

At the start of each odd phase, CLK_{ODD} undergoes an activating change, that is it changes from high to low. At this time, depending on the data signals in the preceding even phase, one of the two switches SW7 and SW8 will already have been turned on, and the other of those two switches will already have been turned off. This means that the change in the clock signal CLK_{ODD} is transmitted via the on switch to the relevant output node without having to turn on the switch concerned. In other words, the switch is turned on in advance of the activating change in the clock signal. Accordingly, the activating change in the clock signal is delivered to the required output node with as small a delay as possible. This means that the inputs to the gates of the FETs in the differential switch circuit 10 of Figure 3 change as quickly as possible. Although it is still possible for there to be delay mismatch between, for example, the switches SW7 and SW8, this mismatch should be small because the delays imposed by the switches themselves are small.

Accordingly, the switch driver circuitry 12 in Figure 4 is effective in reducing the effect of switching delay mismatches. However, the present applicants are now contemplating a DAC capable of operating at a much higher conversion frequency, for example up to 12 Gsamples/s. This imposes some severe requirements on the circuitry. One way of relaxing these requirements is to increase the number of phases beyond two. This enables the decoders to have longer to carry out their decoding operations. For example, it might be contemplated to provide four pairs of switches in the differential switching circuit, instead of the two pairs shown in Figure 3, and four circuits in the switch driver circuitry of Figure 4, instead of the two circuits 14 and 16.

However, in order to increase the number of individual circuits in the switch driver circuitry 12 of Figure 4, it would be necessary to increase the number of clock signals from 2 to 4 as well. These four clock signals would need to be 90° out of phase with one another. Generating and delivering such multiphase clock signals to all of the different segments would be very difficult to do in practice. In the switch driver circuitry, the clock signals are used directly to provide the drive signals to the FETs in the differential switching circuitry. It follows that any timing errors in the clock signals will affect the performance of the differential switching circuitry directly.

It is therefore desirable to provide switch driver circuitry capable of multiphase operation without timing errors affecting the drive signals produced by the circuitry.

According to a first aspect of the present invention there is provided switch driver circuitry as defined in independent claim 1, to which the reader should now refer. Optional features are defined in the dependent claims.

Each said driver circuit may also comprise means for maintaining said output node at a predetermined potential when the clock switch is off, said predetermined potential preferably being substantially equal to the potential of the clock signal received at said clock input node prior to said preselected change.

The maintaining means may comprise a further switch connected between said output node and a source of said predetermined potential, said switch controller preferably being operable to turn on said further switch when said clock switch is turned off.

Preferably, the driver circuit also has a data input node at which a data signal is received, and the switch controller is preferably operable to employ the data signal to determine whether or not to turn on the clock switch during said active period of the received mask signal.

Each said driver circuit may have first and second output nodes and first and second clock switches, said first clock switch being connected between said clock input node and said first output node and said second clock switch being connected between said clock input node and said second output node, and the switch controller may be operable to select one of the first and second clock switches in dependence upon said data signal and to turn on the selected clock switch in advance of said preselected change.

The switch controller may comprise a latch connected for receiving said data signal and a signal complementary thereto and also connected for receiving said mask signal, the latch having a first output connected to a control terminal of said first clock switch and a second output connected to a control terminal of said second clock switch, the latch being arranged so that during said inactive period of the mask signal the first and second outputs are both in an OFF state, in which the first and second clock signals are off and so that, at the start of each active period of the mask signal, one of the first and second outputs changes from an OFF state to an ON state, in which said one clock switch is turned ON, and the other of the two outputs remains in the OFF state, the first and second outputs remaining unchanged if the data input changes subsequently during the active period concerned.

The mask generator circuit may be operable to cause said active period of the mask signal received by each said driver circuit to begin prior to a first preselected change in the clock signal received at the clock input node of the driver circuit concerned and to end after a second preselected change in that clock signal.

The first and second preselected changes may be successive edges of the clock signal concerned, one of the edges being a rising edge and the other of the edges being a falling edge.

Any changes in the data signal at the data input node of one of the driver circuits may be made during an inactive period of the mask signal received at the mask input node of the driver circuit concerned.

The circuitry may further comprise means for adjusting a duty cycle of said one or more clock signals applied to the mask generating circuit.

According to an embodiment of a second aspect of the present invention there is provided switching circuitry comprising: switch driver circuitry according to the aforementioned first aspect of the present invention; and a switching circuit having a plurality of switchable elements, each connected to one of the said output nodes of the switch driver circuitry for receiving respective drive signals therefrom.

The switching circuit may be a differential switching circuit having a common node and first and second switch nodes, the plurality of switchable elements being operable to connect the common node to a selected one of the first and second switch nodes in each of said phases. Preferably, the number of switchable elements which change state from one phase to the next is constant.

According to an embodiment of a third aspect of the present invention there is provided a digital-to-analog converter comprising switching circuitry according to the aforementioned second aspect of the present invention.

It will be appreciated that method aspects (although not directly embodying the invention claimed) may be provided corresponding respectively to the above three aspects of the present invention. It will further be appreciated that features of the aforementioned first to third aspects of the present invention apply to such methods and vice versa.

According to an embodiment of a fourth aspect of the present invention, there is provided an IC chip or chipset comprising switch driver circuitry according to the aforementioned first aspect of the present invention, or comprising switching circuitry according to the aforementioned second aspect of the present invention, or comprising a digital-to-analog converter according to the aforementioned third aspect of the present invention.

According to an embodiment of a fifth aspect of the present invention, there is provided a circuit board comprising switch driver circuitry according to the aforementioned first aspect of the present invention, or comprising switching circuitry according to the aforementioned second aspect of the present invention, or comprising a digital-to-analog converter according to the aforementioned third aspect of the present invention.

According to an embodiment of a sixth aspect of the present invention, there is provided an RF transmitter comprising a digital-to-analogue converter according to the aforementioned third aspect of the present invention. Such an RF transmitter may be part of a base station, relay station or a mobile device, and accordingly the present invention extends to this equipment too.

Reference will now be made, by way of example, to the accompanying drawings, in which:
Figure 1, discussed hereinbefore, shows parts of a previously-considered DAC;
Figure 2, also discussed hereinbefore, shows parts of differential switching circuitry previously considered for use in the Figure 1 DAC;
Figure 3 another example of differential switching circuitry previously considered suitable for use in the Figure 1 DAC;
Figure 4 shows parts of switch driver circuitry previously considered for use in a DAC;
Figure 5 shows parts of a DAC embodying the present invention;
Figure 6 shows switch driver circuitry according to an embodiment of the present invention;
Figure 7 shows one of the parts of the switch driver circuitry of Figure 6;
Figure 8 shows another of the parts of the Figure 6 switch driver circuitry;
Figure 9 shows differential switching circuitry suitable for use with the Figure 6 switch driver circuitry;
Figures 10(A) and 10(B) show waveforms generated by the Figure 6 switch driver circuitry in operation; and
Figure 11 shows one part of switch driver circuitry according to another embodiment of the present invention.

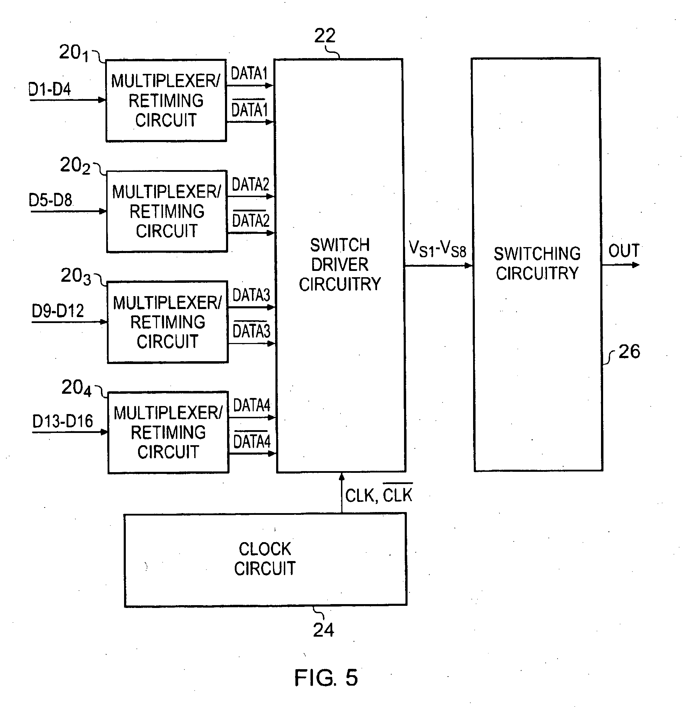

Figure 5 shows parts of a DAC embodying the present invention. The DAC is intended to have a conversion frequency of up to 12 G samples/s. Such a DAC may be used, for example, to synthesise a radio-frequency (RF) signal in a mobile telephone base station. The DAC is segmented and has a plurality of analog segments in the same basic manner as the DAC of Figure 1.

The parts of the DAC shown in Figure 5 are mainly parts of the analog circuitry of the DAC. The DAC also comprises digital circuitry that is not shown in Figure 5. This digital circuitry, for example, includes an array of decoders (for example 16 decoders), each of which carries out binary-to-thermometer decoding operations. With 16 decoders and a DAC conversion frequency of 12 G samples/s, each individual decoder is required to perform 750 million decoding operations per second.

The DAC analog circuitry comprises four multiplexer/retiming circuits 20₁ to 20₄. Each of these multiplexer/retiming circuits 20₁ to 20₄ receives the decoded data signals produced by four of the decoders of the decoder array. Each multiplexer/retiming circuit performs time-division multiplexing on the decoded data signals received from its four decoders to produce a stream of multiplexed data signals. The data signals are of the complementary type, and also there is one pair of complementary data signals per analog segment. For simplicity in Figure 5, only one such pair of complementary data signals is shown. Thus, the complementary data signals produced by the multiplexer/retiming circuit it 20₁ are the signals DATA 1 and D̅A̅T̅A̅1̅, the complementary data signals produced by the multiplexer/retiming circuit 20₂ are the signals DATA 2 and D̅A̅T̅A̅2̅, the complementary data signals produced by the multilplexer/retiming circuit 20₃ are the signals DATA 3 and D̅A̅T̅A̅3̅, and the complementary data signals produced by the multiplexer/retiming circuit 20₄ are the signals DATA 4 and D̅A̅T̅A̅4̅. Changes in each of these pairs of complementary data signals occur at a frequency of 3 GHz.

The four pairs of complementary data signals are supplied from the multiplexer/retiming circuits 20₁ to 20₄ to switch driver circuitry 22. The switch driver circuitry 22 also receives a pair of complementary clock signals CLK and C̅L̅K̅ from a clock circuit 24. The frequency of each of the clock signals CLK and C̅L̅K̅ is 6 GHz.

The switch driver circuitry 22 is segmented into n segments. Each of the segments receives the four pairs of complementary data signals (DATA 1 to DATA 4 and D̅A̅T̅A̅1̅ to D̅A̅T̅A̅4̅). Each segment derives from the received complementary data-signal parts and the complementary clock signals CLK and C̅L̅K̅ a set of 8 drive signals V_{S1} to V_{S8}.

The analog circuitry in Figure 5 further comprises differential switching circuitry 26 which is also segmented into n segments. Each segment of the differential switching circuitry receives the 8 drive signals V_{S1} to V_{S8} produced by the corresponding segment of the switch driver circuitry 22 and produces an analog output signal for its segments. The respective analog output signals of the n segments of the differential switching circuitry 26 are then combined together to produce an analog output signal for the DAC. In this example, changes in the analog output signal can occur at 12 GHz.

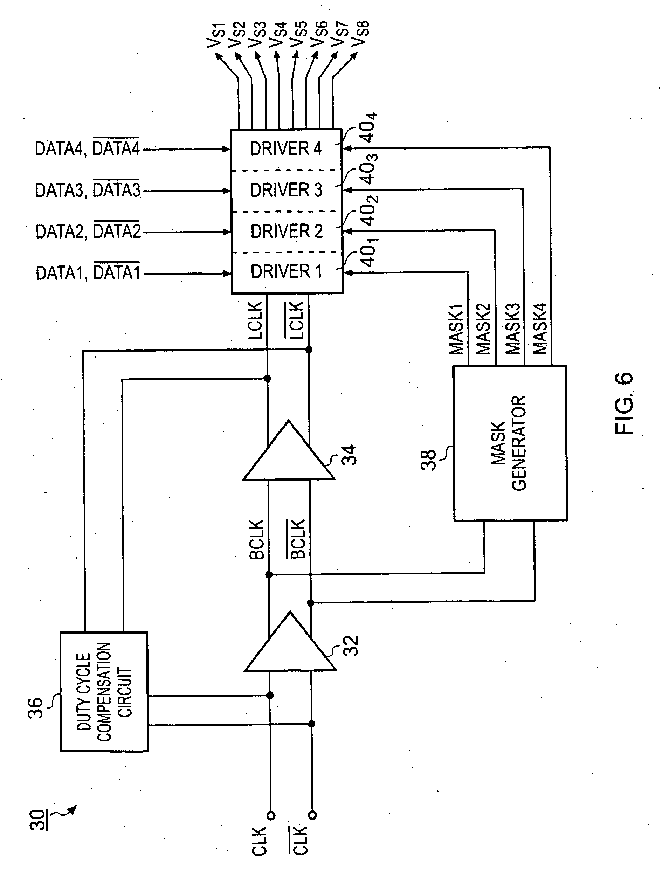

Figure 6 shows the circuitry in one segment of the switch driver circuitry 22 of Figure 5. The segment 30 comprises a buffer 32, a level shift and edge control circuit 34, a duty cycle compensation circuit 36, a mask generator circuit 38 and first to fourth driver circuits 40₁ to 40₄.

The buffer 32 receives the pair of complementary clock signals CLK and C̅L̅K̅ from the clock circuit 24 in Figure 5. The buffer 32 amplifies the received clock signals and supplies buffered complementary clock signals BCLK and B̅C̅L̅K̅ to the level shift and edge control circuit 34. Circuit 34 adjusts the voltage levels and edge timings of the complementary clock signals as necessary and supplies the resulting adjusted clock signals LCLK and L̅C̅L̅K̅ to the driver circuits 40₁ to 40₄.

The duty cycle compensation circuit 36 is connected to the inputs of the buffer 32 and the outputs of the level shift and edge control circuit 34. The duty cycle compensation circuit 36 adjusts the duty cycle of the clock signals so that the adjusted clock signals LCLK and L̅C̅L̅K̅ supplied to the driver circuits 40₁ and 40₄ have a 50% duty cycle.

For example, the clock signals CLK and C̅L̅K̅ may be generated off-chip and AC-coupled onto the chip. The clock paths for CLK and C̅L̅K̅ may have an on-chip centre-tapped termination resistor. The duty cycle compensation circuit may then operate to adjust the common-node voltage of the clock signals CLK and C̅L̅K̅. This can be achieved by adding a voltage difference to the differential clock signals, for example by adjusting the equivalent termination voltages of the differential clock signals. This effectively moves the crossover point of the two waveforms (the rising/falling crossover is adjusted one way, and the falling/rising crossover is adjusted the other way), which adjusts the duty cycle. The adjustment can be carried out in many different ways. For example, it is possible to move each actual termination voltage (these being driven from the amplifiers). It is also possible to add to a differential current at the termination resistors. It is also possible to use "split" termination resistors with slightly more than an intended impedance to the centre tap and much higher impedance to an amplifier output which provides a DC offset. For example, when the intended impedance is 50Ω, the split resistors may be 55Ω and 500Ω. These possibilities are all equivalent to adding an input offset voltage to the differential clock signal to move the crossovers in opposite directions. The clock signals CLK and C̅L̅K̅ may be approximately sinusoidal at the intended operating frequencies.

It would also be possible to connect the duty cycle compensation circuit 36 to circuitry within the buffer 32 to adjust the output skew rates of the buffer.

The buffered clock signals BCLK and B̅C̅L̅K̅ produced by the buffer 32 are also applied to the mask generator circuit 38. The mask generator circuit derives first to fourth mask signals MASK 1, MASK 2, MASK 3 and MASK 4 from the buffered clock signals and supplies them respectively to the first to fourth driver circuits 40₁ to 40₄. The mask signals each have a frequency of half the frequency of the clock signals CLK and C̅L̅K̅. The different mask signals are 90° out of phase with one another.

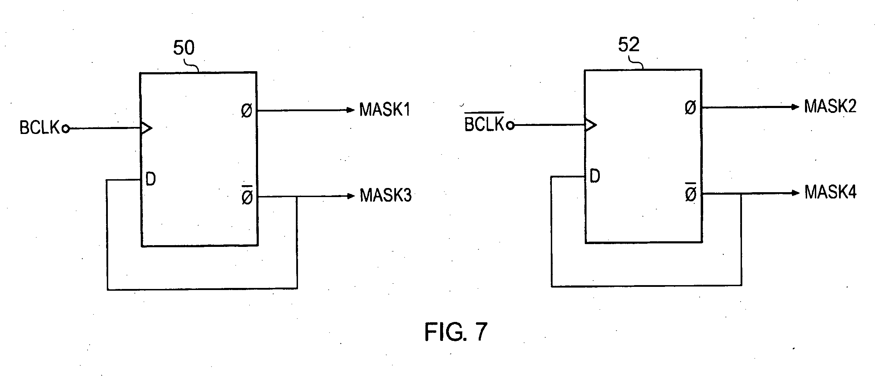

Figure 7 shows one example implementation of the mask generator 38 in Figure 6. The mask generator 38 comprises first and second flip-flops 50 and 52. Each flip-flop has its Q̅ output connected to its D input. Accordingly, each flip-flop operates as a divide-by-two circuit. The first flip-flop 50 receives at its clock input the buffered clock signal BCLK. This flip-flop generates at its Q output the first mask signal MASK 1 and generates at its Q̅ output the third mask signal MASK 3. Accordingly, at each rising edge of BCLK the outputs MASK 1 and MASK 3 change state. Similarly, in the case of the second flip-flop 52, the second and fourth mask signals MASK 2 and MASK 4 change state at each rising edge of B̅C̅L̅K̅. Because the mask signals are generated using divide-by-two circuits, they each have a 50% duty cycle, without requiring any additional duty cycle correction circuitry.

Coming back to Figure 6, each of the four driver circuits 40₁ to 40₄ receives the pair of complementary decoded data signals for the segment concerned. Each driver circuit also receives one of the four mask signals MASK 1 to MASK 4. Each of the driver circuits 40₁ to 40₄ produces two of the eight drive signals. The driver circuit 40₁ produces the drive signals V_{S1} and V_{S2}, the driver circuit 40₂ produces the drive signals V_{S3} and V_{S4}, the driver circuit 40₃ produces the drive signals V_{S5} and V_{S6}, and the driver circuit 40₄ produces the drive signals V_{S7} and V_{S8}.

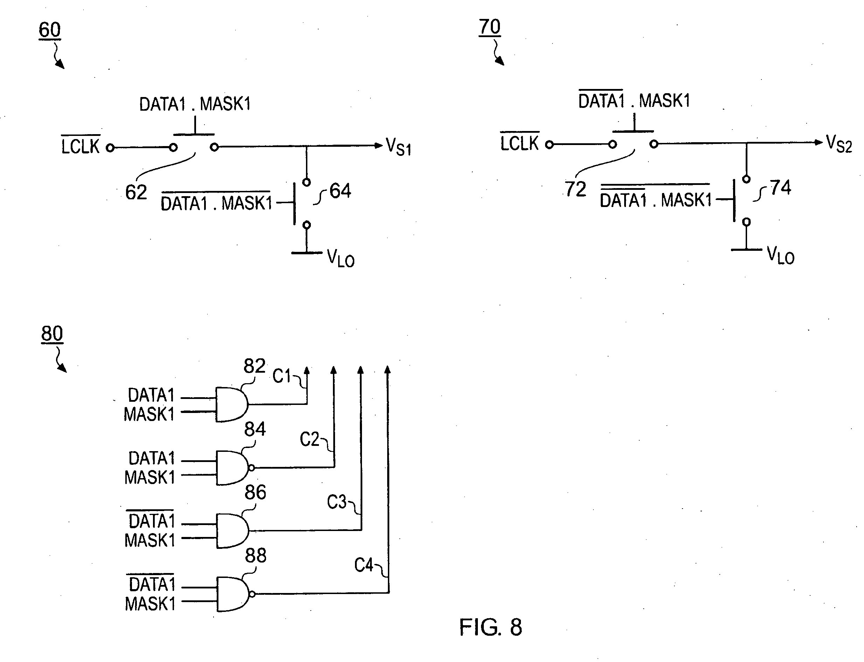

Figure 8 shows an example implementation of the first driver circuit 40₁. The driver circuit 40₁ in this example has a first driver portion 60 and a second driver portion 70. The driver circuit 40₁ also comprises a switch controller 80.

The first driver portion 60 is used to provide the drive signal V_{S1}. The first driver portion 60 comprises a switch 62 (hereinafter a "clock switch") connected between a clock input node of the first driver portion 60 and an output node of the driver portion. The adjusted clock signal L̅C̅L̅K̅ is received at the clock input node. The clock switch 62 is controlled by a first control signal C1 generated by the switch controller 80. The switch controller 80 comprises an AND gate 82 which receives at its inputs the data signal DATA 1 and the mask signal MASK 1. Thus, C1=DATA 1.MASK 1.

The first switch driver portion 60 further comprises a switch 64 connected between the output node and a node of the driver portion which is maintained at a predetermined low potential V_{LO}. This low potential V_{LO} is maintained at substantially the same potential as the potential of each of the adjusted clock signals LCLK and L̅C̅L̅K̅ when in the low (inactive) state. The switch controller 80 comprises a NAND gate 84 which, similarly to the AND gate 82, receives the signals DATA 1 and MASK 1 at its inputs. The output signal C2 of the NAND gate 84 is therefore D̅A̅T̅A̅ 1̅.̅M̅A̅S̅K̅ 1̅.

The second switch driver portion 70 provides the drive signal V_{S2}. This second driver portion 70 has a clock input node at which the clock signal L̅C̅L̅K̅ is received. A clock switch 72 is arranged between the clock input node and the output node of the second driver portion 70. This switch 72 is controlled by a control signal C3 produced by the switch controller 80. The switch controller 80 comprises an AND gate 86 which receives at its inputs the inverted data signal D̅A̅T̅A̅1̅ and the mask signal MASK 1. Thus C3=D̅A̅T̅A̅1̅.MASK 1.

The second switch driver portion 70 further comprises a switch 74 connected between the output node and the node having the potential V_{LO}. This switch is controlled by a control signal C4 produced by a NAND gate 88 in the switch controller 80. The inputs to the NAND gate 88 are the same as the inputs to the AND gate 86 so that C4=DATA 1+M̅A̅S̅K̅1̅.

The other driver circuits 40₂ to 40₄ are implemented in basically the same manner as the first driver circuit 40₁. Table 1 below shows any differences in the connection arrangements. Each row in column 1 corresponds to one of the two switch driver portions in a driver circuit. For example, the entries for the third row (V_{S3}) show that the driver portion used to generate the drive signal V_{S3} has LCLK connected to its clock input node, DATA 2.MASK 2 applied to its clock switch and D̅A̅T̅A̅ 2̅.̅M̅A̅S̅K̅ 2̅ applied to its other switch.

**Table 1**

| | Clock input node | Clock switch | Other switch |
|---|---|---|---|
| V_{S1} | L̅C̅L̅K̅ | DATA 1.MASK 1 | D̅A̅T̅A̅1̅.̅M̅A̅S̅K̅1 |
| V_{S2} | L̅C̅L̅K̅ | D̅A̅T̅A̅1̅.̅M̅A̅S̅K̅1̅ | DATA1+M̅A̅S̅K̅1̅ |
| V_{S3} | L̅C̅L̅K̅ | DATA 2.MASK 2 | D̅A̅T̅A̅2̅.̅M̅A̅S̅K̅2̅ |
| V_{S4} | L̅C̅L̅K̅ | DATA 1.MASK 1 | DATA2+M̅A̅S̅K̅1̅ |
| V_{S5} | L̅C̅L̅K̅ | DATA 3.MASK 3 | DATA 3.MASK 3 |
| V_{S6} | LCLK | D̅A̅T̅A̅3̅.̅M̅A̅S̅K̅3̅ | D̅A̅T̅A̅3̅+̅M̅A̅S̅K̅3̅ |
| V_{S7} | LCLK | DATA 4.MASK 4 | D̅A̅T̅A̅4̅.̅M̅A̅S̅K̅4̅ |
| V_{S8} | LCLK | D̅A̅T̅A̅4̅.̅M̅A̅S̅K̅ 4 | DATA 4+M̅A̅S̅K̅4̅ |

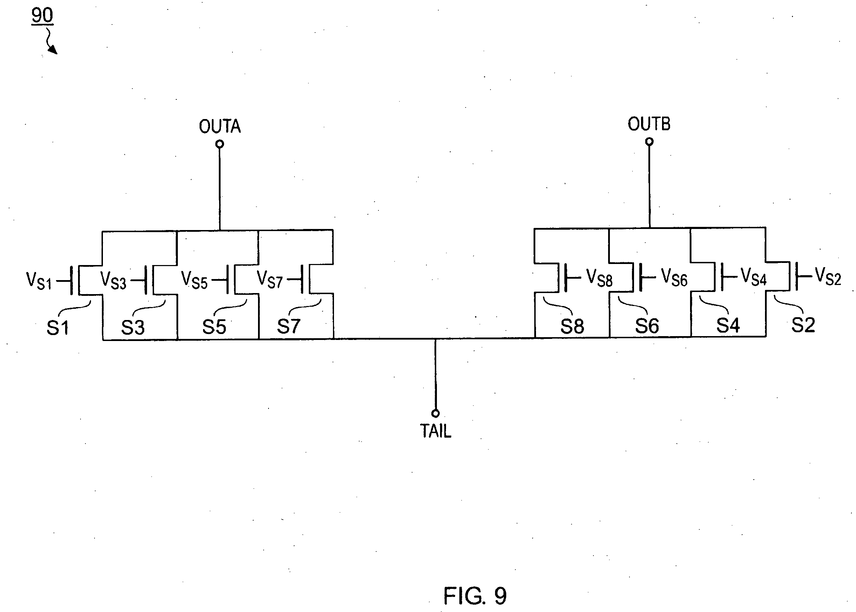

Figure 9 shows an example of the implementation of one segment of the differential switching circuitry 26 in Figure 5. The circuitry 90 in the segment comprises 8 FETs S1 to S8 which, in this example, are all n-type devices. The FETs are arranged in first to fourth pairs, with each pair having a first FET connected between a first output node OUTA of the circuitry and a common node TAIL and a second FET connected between a second output node OUTB of the circuitry and the common node TAIL.

Each of the FETs receives one of the drive signals V_{S1} to V_{S8} produced by the corresponding segment (Figure 8) of the switch driver circuitry 22.

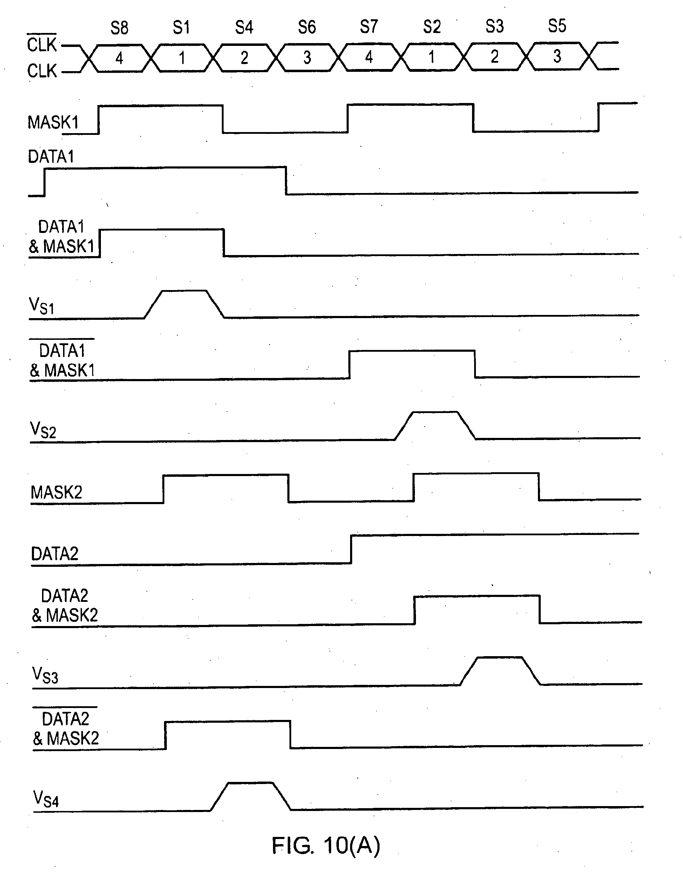

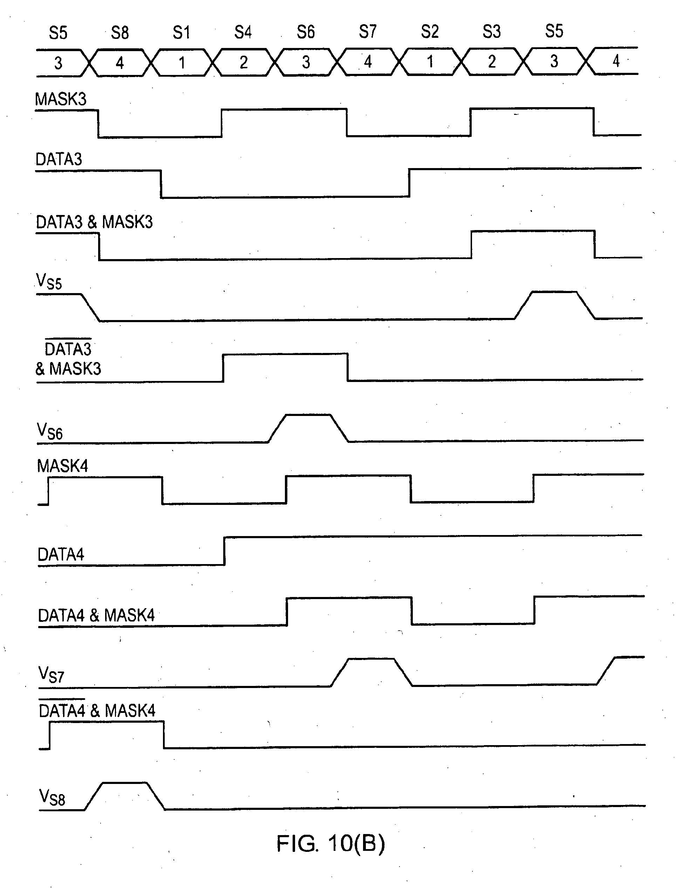

Operation of the DAC of Figures 5 to 9 will now be described with reference to the timing diagrams of Figures 10(A) and 10(B).

As shown in the timing diagrams, the DAC operates in a repeating sequence of four phases. These phases are identified in the diagrams showing the complementary clock signals CLK and C̅L̅K̅ in Figures 10(A) and 10(B).

It is assumed that, in the first phase labelled "4" in the figures, the FET S8 in Figure 9 is on and all of the other FETs S1 to S7 are off. The first mask signal MASK 1 changes to the high level near to the beginning of that phase 4. This change is triggered by the rising edge in BCLK. This causes the mask signals MASK 1 and MASK 3 to change state, as described previously with reference to Figure 7. The precise timing at which the mask signal MASK 1 changes to the high level is not critical. All that matters is that MASK 1 changes to the high level in advance of the next rising edge in C̅L̅K̅, for reasons that will become apparent.

As can be seen from Figure 10(A), at a time before the rising edge of MASK 1, the data signal DATA 1 was changed from the low level to the high level (the timing is actually during the preceding phase 3). This change in the data signal DATA 1 denotes that in the coming phase 1, out of the transistors S1 and S2 in the first pair, the transistor S1 should be turned on and the other transistor S2 should be turned off. The driver circuit 40₁ receives the data signal DATA 1 and the mask signal MASK 1. When these signals are both high, i.e. at the rising edge of MASK 1 in phase 4, the clock switch 62 is turned on (it was previously off) and the other switch 64 is turned off (it was previously on). In phase 4 the clock signal L̅C̅L̅K̅ has substantially the same potential as the potential V_{LO}, so changing the states of the switches 62 and 64 during phase 4 does not affect the drive signal V_{S1} which remains at V_{LO}.

However, as soon as L̅C̅L̅K̅ changes from low to high at the beginning of phase 1, this change is passed via the clock switch 62 directly to the gate of the FET S1 so that the FET S1 is turned on at substantially the same time as L̅C̅L̅K̅ rises.

It can therefore be seen that the timing of the rising edge in the drive signal V_{S1} is controlled exclusively by the clock signal L̅C̅L̅K̅, and not by the timing of the mask signal MASK 1 or the timing of the data signal DATA 1. Accordingly, even if there is jitter in MASK 1 and DATA 1 this will not affect the operation of the circuitry.

In the case of the drive signal V_{S2} for the FET S2, this remains fixed at V_{LO} in phase 1 because D̅A̅T̅A̅1̅ is low in phase 1. Accordingly, the clock signal L̅C̅L̅K̅ present at the clock input node of the second driver portion 70 in Figure 8 is not passed through to the output node thereof.

The switch S1 is turned off at the end of phase 1 by the falling edge of L̅C̅L̅K̅. For this reason, the mask signal MASK 1 must remain at the high level until at least after that falling edge. Accordingly, again, the timing of the falling edge in V_{S1} is determined exclusively by the clock signal L̅C̅L̅K̅ and is uninfluenced by the mask signal MASK 1 or the data signal DATA 1.

In the next phase (phase 2) the switch S4 is turned on. The data signal DATA 2 which causes this to happen is set at a time when the related mask signal MASK 2 is at the low level, for example some time during the preceding phase 4. In this case, the data signal DATA 2 is unchanged and remains at the low level. Accordingly, the clock switch 62 in the driver portion for V_{S3} remains off (the other switch 64 remains on) and the clock switch 72 in the driver portion for V_{S4} remains on (the other switch 74 remaining off). Thus, V_{S3} remains at V_{LO} in phase 2 and V_{S4} rises with LCLK at the beginning of phase 2 and falls with LCLK at the end of phase 2.

The process continues in the subsequent phases 3, 4, etc. During the inactive period of the third mask signal MASK 3, the data signal DATA 3 is changed from high to low (around the beginning of the first "phase 1" shown in Figure 10(B)). Accordingly, at the rising edge of the MASK 3 near to the beginning of the first "phase 2" in Figure 10(B) the clock switch 72 in the driver portion for V_{S6} is changed from off to on. At the same time, the other switch 74 in that driver portion is changed from on to off. No change in the drive signal V_{S6} occurs until the rising edge of L̅C̅L̅K̅ in phase 3. The drive signal V_{S6} then changes back to V_{LO} at the end of phase 3, when the clock signal L̅C̅L̅K̅ has its next falling edge. During phase 3, the other FET of the same pair, S5, is kept off because the data signal DATA 3 is low.

In the subsequent phase 4, S7 is turned on. The data signal DATA 4 is changed from low to high during the preceding inactive period of the mask signal MASK 4 (around the beginning of the preceding phase 2). Accordingly, the clock switch 62 in the driver portion for the drive signal V_{S7} is turned on at the rising edge of MASK 4 (near to the beginning of phase 3). The other switch 64 in that driver portion is turned off at this time. Accordingly, at the beginning of phase 4, the clock signal LCLK is delivered via the clock switch to the switch S7. The other FET of the same pair, S8, is maintained off in phase 4 because D̅A̅T̅A̅4̅ is low.

It can therefore be seen that in the DAC of Figures 5 to 9, the mask signals are used to enable or disable the drive signals V_{S1} to V_{S8} for the FETs in the differential switching circuitry. However, these mask signals are not used to control the timing of the changes in the drive signals. The timing of those changes is determined by the timing of the complementary clock signals themselves.

The generation of the four mask signals from the complementary clock signals is simple to achieve. Also, the timing of the changes in the mask signals is not especially critical. As mentioned above, all that matters is that each active period of the mask signal begins before the relevant rising edge of the clock signal LCLK/L̅C̅L̅K̅ and ends after the falling edge of that clock signal. Jitter, if any, on the mask signals does not affect the timing of the changes in the drive signals.

It will also be appreciated that the embodiment of Figures 5 to 9 can operate using only a pair of complementary clock signals (the clock signals CLK and C̅L̅K̅). It is therefore unnecessary to generate, and distribute over the chips, four clock signals that are out of phase with one another by 90°.

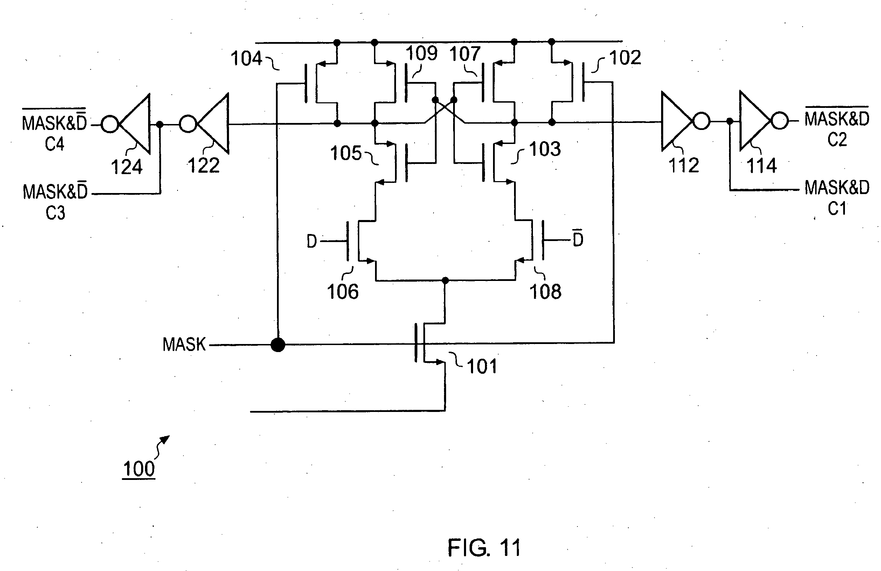

Figure 11 shows another example of the possible implementation of the switch controller in the mask generator circuit 38. Instead of using AND and NAND gates as in the switch controller 80 shown in Figure 8, it is possible to use latches. For example, a latch 100 has the data signal DATA 1 applied to its data input D. The mask signal MASK 1 is applied to its clock input CLK.

The latch 100 is a so-called "strong-arm" latch and operates as follows. When MASK 1 is low, transistors 102 and 104 are ON, so that the outputs C1 and C3 of inverters 112 and 122 are both low and the outputs C2 and C4 of inverters 114 and 124 are both high. Transistor 101 is OFF. When MASK 1 changes from low to high, transistor 101 turns ON. In this condition, if DATA 1 is high, transistor 106 will be ON and transistor 108 will be OFF, so that the input to inverter 122 goes low. This turns ON transistor 107 which forces the input of inverter 112 to go high. Thus, C1 stays low, C2 stays high, C3 becomes high and C4 becomes low. On the other hand, if DATA 1 is low, transistor 108 will be ON and transistor 106 will be OFF, so that the input to inverter 112 goes low. This turns ON transistor 109 which forces the input of inverter 122 to go high. Thus, C1 becomes high, C2 becomes low, C3 stays low and C4 stays high.

If DATA 1 and D̅A̅T̅A̅1̅ change when MASK 1 is high, no change occurs in the output C1 to C4 because transistor 103 turns OFF in the event that transistor 107 turned ON when MASK 1 became high, and transistor 105 turns OFF in the event that transistor 109 turned ON when MASK 1 became high.

Thus, the output C1 = DATA 1.MASK 1, the output C2 = D̅A̅T̅A̅1̅.̅M̅A̅S̅K̅1̅, the output C3 = D̅A̅T̅A̅1̅.MASK 1, and the output C4 = D̅A̅T̅A̅1̅.MASK 1 as in Figure 8.

Further latches of the same kind as shown in Figure 11 can be used to generate the required control signals for the other switch driver circuits based on DATA 2-4. D̅A̅T̅A̅2̅-̅4̅ and MASK 2-4.

One advantage of the Figure 11 circuitry over the corresponding gate circuitry 80 in Figure 8 is that problems associated with different gates having different delays are avoided. Also, the latch outputs have a return-to-zero format which results in a constant supply current. This gives the further advantage that the supply current is independent of the data signals. This may make it possible to use the power supply for the analog circuits to power the latches, too.

Although the embodiment described above operates in four phases, it will be appreciated that the number of phases is not limited to four. Three phases could be used, or five or more phases could be used. In general, the more phases that are used, the greater the interval between successive active periods of the mask signals. This gives more time to change the data signals during these inactive periods. However, the more phases that are used, the greater the number of FETs in the differential switching circuitry and hence the more parasitic capacitances associated with those FETs. This can mean that the circuitry will operate less fast. The use of four phases therefore seems a good compromise for operation at 12 G samples/s.

The present invention is also applicable in other situations in which it is desirable to generate carefully controlled drive signals for a plurality of different switchable elements (e.g. FETs). For example, the present invention is applicable in high-speed input/output circuits. In such circuits, a plurality of circuitry portions may need to be connected to the same input or output node. In this case, a plurality of switchable elements may be provided between the input or output node and the circuitry portions. These switchable elements can be controlled by switch driver circuitry embodying the present invention.

Although embodiments of the present invention have been described for use with differential switching circuitry, it is of course possible to use the invention in situations where there is no differential switching circuitry. For example, the invention could be applied to a single-ended multiplexer as well.

## Claims

1. Switch driver circuitry (22) for driving a switching circuit (26), the circuitry being configured to operate in a repeating sequence of n phases, where n ≥ 3, and comprising:
a mask generator circuit (38) connected for receiving one or more first clock signals and operable to derive therefrom a set of n mask signals which differ in phase one from the next by 360/n°; and
n driver circuits (40₁ to 40₄), each having a mask input node at which a respective one of said n mask signals is received and a clock input node at which a second clock signal is received, that second clock signal being related in timing to said one or more first clock signals such that it has a preselected change of state during an active period of the received mask signal, and each said driver circuit also having a clock switch (62, 72) connected between its clock input node and an output node of that driver circuit and also having a switch controller (80) operable to employ the mask signal received at the mask input node of that driver circuit to turn on the clock switch of that driver circuit in advance of the preselected change of state of the second clock signal received at the clock input node of that driver circuit based on the active period of the mask signal received at the mask input node of that driver circuit so as to connect its clock input node to its output node.

2. Circuitry as claimed in claim 1, wherein each said driver circuit also comprises means (80, 64, 74) for maintaining its output node at a predetermined potential when its clock switch is off, said predetermined potential being substantially equal to the potential of the second clock signal received at its clock input node prior to the preselected change of state concerned.

3. Circuitry as claimed in claim 2, wherein each said maintaining means comprises a further switch (64, 74) connected between the output node of the driver circuit concerned and a source of said predetermined potential, the switch controller (80) of that driver circuit being operable to turn on that further switch (64, 74) when the clock switch of that driver circuit is turned off.

4. Circuitry as claimed in any preceding claim, wherein:
each said driver circuit also has a data input node at which a data signal is received; and
for each said driver circuit, the switch controller (80) is operable to employ the data signal concerned to determine whether or not to turn on the clock switch (62, 72) concerned during said active period of the respective received mask signal.

5. Circuitry as claimed in claim 4, wherein:
each said driver circuit has first and second output nodes and first and second clock switches (62 & 72), said first clock switch (62) being connected between said clock input node and said first output node and said second clock switch (72) being connected between said clock input node and said second output node; and
for each said driver circuit, the switch controller (80) is operable to select one of the first and second clock switches in dependence upon said data signal and to turn on the selected clock switch in advance of said preselected change of state.

6. Circuitry as claimed in claim 5, wherein, for each said driver circuit, the switch controller comprises a latch connected for receiving said data signal and a signal complementary thereto and also connected for receiving said mask signal, the latch having a first output connected to a control terminal of said first clock switch and a second output connected to a control terminal of said second clock switch, the latch being arranged so that during said inactive period of the mask signal the first and second outputs are both in an OFF state, in which the first and second clock signals are off and so that, at the start of each active period of the mask signal, one of the first and second outputs changes from an OFF state to an ON state, in which said one clock switch is turned ON, and the other of the two outputs remains in the OFF state, the first and second outputs remaining unchanged if the data input changes subsequently during the active period concerned.

7. Circuitry as claimed in any preceding claim, wherein said mask generator circuit (38) is operable to cause said active period of the mask signal received by each said driver circuit to begin prior to a first preselected change of state in the second clock signal received at the clock input node of the driver circuit concerned and to end after a second preselected change of state in that second clock signal.

8. Circuitry as claimed in claim 7, wherein said first and second preselected changes of state are successive edges of the second clock signal concerned, one of the edges being a rising edge and the other of the edges being a falling edge.

9. Circuitry as claimed in any of claims 5 to 8, wherein any changes in the data signal at the data input node of one of the driver circuits are made during an inactive period of the mask signal received at the mask input node of the driver circuit concerned.

10. Circuitry as claimed in any preceding claim, further comprising means for adjusting a duty cycle of said one or more first clock signals applied to the mask generating circuit.

11. Switching circuitry comprising:
switch driver circuitry (22) as claimed in any preceding claim; and
a switching circuit (26) having a plurality of switchable elements (51 to 58), each connected to one of the said output nodes of the switch driver circuitry for receiving respective drive signals therefrom.

12. Switching circuitry as claimed in claim 11, wherein said switching circuit is a differential switching circuit having a common node and first and second switch nodes, the plurality of switchable elements (51 to 58) being operable to connect the common node to a selected one of the first and second switch nodes in each of said phases.

13. Switching circuitry as claimed in claim 12, wherein the number of switchable elements which change state from one phase to the next is constant.

14. A digital-to-analogue converter comprising switching circuitry as claimed in any of claims 11 to 13.

15. An IC chip or chipset comprising switch driver circuitry as claimed in any of claims 1 to 10, or comprising switching circuitry as claimed in any of claims 11 to 13, or comprising a digital-to-analogue converter as claimed in claim 14.

16. A circuit board comprising switch driver circuitry as claimed in any of claims 1 to 10, or comprising switching circuitry as claimed in any of claims 11 to 13, or comprising a digital-to-analogue converter as claimed in claim 14.

17. An RF transmitter comprising a digital-to-analogue converter as claimed in claim 14.

18. A base station, a relay station or a mobile device, comprising an RF transmitter as claimed in claim 17.

## Patentansprüche

1. Schalterantriebsschaltung (22) zum Antreiben einer Schaltungsanordnung (26), wobei die Schaltung eingerichtet ist, in einer wiederholenden Sequenz von n Phasen zu arbeiten, wobei n ≥ 3, umfassend:
eine Maskenerzeugungsschaltung (38), verbunden zum Empfangen einer oder mehrere erster Taktsignale und eingerichtet zum Ableiten davon eines Satzes von n Maskensignalen, die sich hinsichtlich der Phase einer von den nächsten um 360/n° unterscheiden; und
n Antriebsschaltungen (40₁ bis 40₄), von denen jede einen Maskeneingabeknoten, an dem ein entsprechendes der n Maskensignale empfangen wird, und einen Takteingabeknoten, an dem ein zweites Taktsignal empfangen wird, aufweist, wobei das zweite Taktsignal hinsichtlich einer Zeitsteuerung mit den einen oder mehr ersten Taktsignalen zusammenhängt, sodass es eine vorausgewählte Zustandsänderung während einer aktiven Periode des empfangenen Maskensignals aufweist, und wobei jede Antriebsschaltung auch einen Taktschalter (62, 72) aufweist, der zwischen seinem Takteingabeknoten und einem Ausgabeknoten dieser Antriebsschaltung verbunden ist und auch eine Schaltsteuerung (80) aufweist, die eingerichtet ist zum Anwenden des Maskensignals, das an dem Maskeneingabeknoten dieser Antriebsschaltung empfangen wird, um den Taktschalter dieser Antriebsschaltung anzuschalten vor der vorausgewählten Zustandsänderung des an dem Takteingabeknoten dieser Antriebsschaltung empfangenen zweiten Taktsignals basierend auf der aktiven Periode des Maskensignals, das an dem Maskeneingabeknoten dieser Antriebsschaltung empfangen wird, um seinen Takteingabeknoten mit seinem Ausgabeknoten zu verbinden.

2. Schaltung nach Anspruch 1, wobei die Antriebsschaltung auch ein Mittel (80, 64, 74,) umfasst, zum Beibehalten seines Ausgangsknotens an einem vorbestimmten Potenzial, wenn sein Taktschalter aus ist, wobei das vorbestimmte Potenzial im Wesentlichen gleich dem Potenzial des zweiten Taktsignals ist, das an seinem Takteingabeknoten vor der vorausgewählten Zustandsänderung, die betroffen ist, empfangen wird.

3. Schaltung nach Anspruch 2, wobei das Beibehaltungsmittel weiterhin einen weiteren Schalter (64, 74) umfasst, der zwischen dem Ausgangsknoten der betroffenen Antriebsschaltung und einer Quelle des vorbestimmten Potenzials verbunden ist, wobei die Schaltsteuerung (80) dieser Antriebsschaltung eingerichtet ist zum Anschalten dieses weiteren Schalters (64, 74), wenn der Taktschalter diese Antriebsschaltung ausgeschaltet wird.

4. Schaltung nach einem der vorherigen Ansprüche, wobei:
die Antriebsschaltung auch einen Dateneingabeknoten enthält, an dem ein Datensignal empfangen wird; und
für jeden der Antriebsschaltungen, die Schaltsteuerung (80) eingerichtet ist zum Anwenden des betroffenen Datensignals, um zu bestimmen, ob die betroffenen Taktschaltung (62, 72) während der aktiven Periode des jeweiligen empfangenen Maskensignals anzuschalten ist oder nicht.

5. Schaltung nach Anspruch 4, wobei:
jeder der Antriebsschaltung erste und zweite Ausgangsknoten und erste und zweite Taktschalter (62 und 72) aufweist, wobei der erste Taktschalter (62) zwischen dem Takteingabeknoten und dem ersten Ausgabeknoten verbunden ist und der zweite Taktschalter (72) zwischen dem Takteingabeknoten und dem zweiten Ausgabeknoten verbunden ist; und
für jeden der Antriebsschaltungen, die Schaltsteuerung (80) eingerichtet ist zum Auswählen einer der ersten und zweiten Taktschaltungen in Abhängigkeit von dem Datensignal, und zum Anschalten des ausgewählten Taktschalters vor der vorausgewählten Zustandsänderung.

6. Schaltung nach Anspruch 5, wobei, für jeden der Antriebsschaltungen, die Schaltsteuerung einen Riegel umfasst, der verbunden ist zum Empfangen des Datensignals und eines dazu komplementären Signals und auch verbunden ist zum Empfangen des Maskensignals, wobei der Riegel einen mit einem Steueranschluss des ersten Taktschalters verbundenen ersten Ausgang und einen mit einem Steueranschluss des zweiten Taktschalters verbundenen zweiten Ausgang aufweist, wobei der Riegel eingerichtet ist, sodass während der inaktiven Periode des Maskensignals die ersten und zweiten Ausgänge beide in einem Aus-Zustand sind, in dem die ersten und zweiten Taktsignale aus sind, und sodass, beim Start jeder aktiven Periode des Maskensignals, einer der ersten und zweiten Ausgänge sich von einem Aus-Zustand in einen An-Zustand ändert, in dem ein Taktsignal angeschaltet ist, und der andere der zwei Ausgänge in dem Aus-Zustand verbleibt, wobei die ersten und zweiten Ausgänge unverändert bleiben, wenn sich die Dateneingabe nachfolgend während der betroffenen aktiven Periode verändert.

7. Schaltung nach einem der vorhergehenden Ansprüche, wobei die Maskenerzeugungsschaltung (38) eingerichtet ist zum Veranlassen der aktiven Periode des von der Antriebsschaltung empfangenen Maskensignals vor einer ersten vorausgewählten Zustandsänderung in dem zweiten Taktsignal, das an dem Takteingangsknoten der betroffenen Treiberschaltung empfangen wird, zu beginnen und nach einer zweiten vorausgewählten Zustandsänderung in diesem zweiten Taktsignal zu enden.

8. Schaltung nach Anspruch 7, wobei die ersten und zweiten vorausgewählten Zustandsänderungen sukzessive Kanten des betroffenen zweiten Taktsignals sind, wobei eine der Kanten eine Anstiegskante ist und die andere der Kanten eine Abstiegskante ist.

9. Schaltung nach einem der Ansprüche 5-8, wobei jegliche Änderungen in dem Datensignal an dem Dateneingangsknoten eines der Antriebsschaltungen durchgeführt werden während einer inaktiven Periode des Maskensignals, das an dem Maskeneingangsknoten des betroffenen Antriebsschaltung empfangen wird.

10. Schaltung nach einem der vorhergehenden Ansprüchen, weiterhin umfassend Mittel zum Anpassen eines Betriebszyklus des einen oder mehr ersten Taktsignals, das auf die Maskenerzeugungsschaltung angewandt wird.

11. Schaltanordnung, umfassend:
eine Schalterantriebsschaltung (22) nach einem der vorhergehenden Ansprüchen; und
eine Schaltanordnung (26) mit einer Vielzahl von schaltbaren Elementen (51 bis 58), von denen jede mit einer der Ausgangsknoten der Schalterantriebsschaltung zum Empfangen jeweiliger Antriebssignale davon verbunden ist.

12. Schaltanordnung nach Anspruch 11, wobei die Schaltanordnung eine differenzielle Schaltanordnung ist mit einem gemeinsamen Knoten und ersten und zweiten Schaltknoten, wobei die Vielzahl von schaltbaren Elementen (51 bis 58) eingerichtet sind zum Verbinden des gemeinsamen Knotens mit einem ausgewählten der ersten und zweiten Schaltknoten in jeder der Phasen.

13. Schaltanordnung nach Anspruch 12, wobei die Anzahl von schaltbaren Elementen, die einen Zustand von einer Phase zur nächsten ändern, konstant ist.

14. Digital-/Analogwandler, umfassend eine Schaltanordnung nach einem der Ansprüche 11-13.

15. IC-Chip oder Chipsatz, umfassend eine Schalterantriebsschaltung nach einem der Ansprüche 1-10 oder umfassend eine Schaltanordnung nach einem der Ansprüche 11-13 oder umfassend einen Digital-/Analogwandler nach Anspruch 14.

16. Schaltplatine, umfassend eine Schalterantriebsschaltung nach einem der Ansprüche 1-10 oder umfassend eine Schaltanordnung nach einem der Ansprüche 11-13 oder umfassend einen Digital-/Analogwandler nach Anspruch 14.

17. RF-Sender umfassend einen Analog-/Digitalwandler nach Anspruch 14.

18. Basisstation, Relaisstation oder Mobilvorrichtung, umfassend einen RF-Sender nach Anspruch 17.

## Revendications

1. Circuits d'entraînement de commutateur (22) destinés à entraîner un circuit de commutation (26), lesdits circuits étant configurés pour fonctionner dans une séquence de répétition de n phases, où n ≥ 3, et comprenant :
un circuit de génération de masque (38) relié afin de recevoir un ou plusieurs premier(s) signal/signaux d'horloge et capable de dériver, à partir de celui-ci/ceux-ci, un ensemble de n signaux de masque qui diffèrent des suivants en phase « une » de 360/n° ; et
n circuits d'entraînement (40₁ à 40₄) ayant chacun un noeud d'entrée de masque au niveau duquel l'un desdits n signaux de masque est reçu, et un noeud d'entrée d'horloge au niveau duquel un second signal d'horloge est reçu, ledit second signal d'horloge étant synchronisé avec le(s)dit(s) premier(s) signal/signaux d'horloge de sorte qu'il présente un changement d'état présélectionné pendant une période active dudit signal de masque reçu, et chacun desdits circuits d'entraînement ayant également un commutateur d'horloge (62, 72) relié entre son noeud d'entrée d'horloge et un noeud de sortie dudit circuit d'entraînement et ayant également un contrôleur de commutateur (80) capable d'utiliser ledit signal de masque reçu au niveau dudit noeud d'entrée de masque dudit circuit d'entraînement afin d'actionner ledit commutateur d'horloge dudit circuit d'entraînement avant ledit changement d'état présélectionné dudit second signal d'horloge reçu au niveau dudit noeud d'entrée d'horloge dudit circuit d'entraînement sur la base de ladite période active dudit signal de masque reçu au niveau dudit noeud d'entrée de masque de façon à relier son noeud d'entrée d'horloge à son noeud de sortie.

2. Circuit selon la revendication 1, dans lequel chaque circuit d'entraînement comprend également des moyens (80, 64, 74) destinés à maintenir son noeud de sortie à un potentiel prédéterminé lorsque son commutateur d'horloge est désactivé, ledit potentiel prédéterminé étant sensiblement égal au potentiel dudit second signal d'horloge reçu au niveau de son noeud d'entrée d' horloge avant ledit changement d'état présélectionné concerné.

3. Circuit selon la revendication 2, dans lequel chaque moyen de maintien comprend un autre commutateur (64, 74) relié entre le noeud de sortie dudit circuit d'entraînement concerné et une source dudit potentiel prédéterminé, ledit contrôleur de commutateur (80) dudit circuit d'entraînement étant capable d'activer ledit autre commutateur (64, 74) lorsque le commutateur d' horloge dudit circuit d'entraînement est désactivé.

4. Circuit selon l'une quelconque des revendications précédentes, dans lequel :
chaque circuit d'entraînement possède également un noeud d'entrée de données au niveau duquel un signal de données est reçu ; et
pour chacun desdits circuits d'entraînement, ledit contrôleur de commutateur (80) est capable d'utiliser le signal de données concerné pour déterminer si ledit commutateur d'horloge concerné (62, 72) doit être activé ou non pendant ladite période active dudit signal de masque reçu respectif.

5. Circuit selon la revendication 4, dans lequel :
chacun desdits circuits d'entraînement possède un premier et un second noeuds de sortie et un premier et un second commutateurs d'horloge (62 et 72), ledit premier commutateur d'horloge (62) étant relié entre ledit noeud d'entrée d'horloge et ledit premier noeud de sortie, et ledit second commutateur d'horloge (72) étant relié entre ledit noeud d'entrée d'horloge et ledit second noeud de sortie ; et
pour chacun desdits circuits d'entraînement, ledit contrôleur de commutateur (80) est capable de sélectionner l'un desdits premier et second commutateurs d'horloge selon ledit signal de données, et d'activer le commutateur d'horloge sélectionné avant ledit changement d'état présélectionné.

6. Circuit selon la revendication 5, dans lequel, pour chacun desdits circuits d'entraînement, ledit contrôleur de commutateur comprend un verrou relié afin de recevoir ledit signal de données et un signal complémentaire à celui-ci, et également relié afin de recevoir ledit signal de masque, ledit verrou ayant une première sortie reliée à une borne de contrôle dudit premier commutateur d'horloge et une seconde sortie reliée à une borne de contrôle dudit second commutateur d'horloge, ledit verrou étant prévu de sorte que, pendant ladite période inactive dudit signal de masque, lesdites première et seconde sorties soient dans un état OFF, dans lequel lesdits premier et second signaux d'horloge sont OFF, et de sorte que, au début de chaque période active dudit signal de masque, l'une desdites première et seconde sorties passe d'un état OFF à un état ON, dans lequel ledit commutateur d'horloge est activé, et l'autre des deux sorties reste OFF, lesdites première et seconde sorties restant inchangées si l'entrée de données change par la suite au cours de la période active concernée.

7. Circuit selon l'une quelconque des revendications précédentes, dans lequel ledit circuit de génération de masque (38) est capable de déclencher ladite période active dudit signal de masque reçu par chacun desdits circuits d'entraînement avant un premier changement d'état présélectionné dudit second signal d'horloge reçu au niveau dudit noeud d'entrée d' horloge dudit circuit d'entraînement concerné, et pour y mettre fin après un second changement d'état présélectionné dudit second signal d'horloge.

8. Circuit selon la revendication 7, dans lequel lesdits premier et second changements d'état présélectionnés sont des fronts successifs du second signal d'horloge concerné, l'un desdits fronts étant un front ascendant et l'autre desdits fronts étant un front descendant.

9. Circuit selon l'une quelconque des revendications 5 à 8, dans lequel tout changement dudit signal de données au niveau dudit noeud d'entrée de données desdits circuits d'entraînement est effectué pendant une période inactive dudit signal de masque reçu au niveau dudit noeud d'entrée de masque dudit circuit d'entraînement concerné.

10. Circuit selon l'une quelconque des revendications précédentes, qui comprend en outre des moyens destinés à ajuster un cycle de fonctionnement dudit ou desdits premier(s) signal/signaux d'horloge appliqué(s) audit circuit de génération de masque.

11. Circuits de commutation qui comprennent :
des circuits d'entraînement de commutateur (22) selon l'une quelconque des revendications précédentes ; et
un circuit de commutation (26) ayant une pluralité d'éléments commutables (51 à 58), chacun reliés à l'un desdits noeuds de sortie desdits circuits d'entraînement de commutateur afin de recevoir des signaux d'entraînement respectifs de sa part.

12. Circuits de commutation selon la revendication 11, dans lesquels ledit circuit de commutation est un circuit de commutation différentiel ayant un noeud commun et un premier et un second noeuds de commutateur, ladite pluralité d'éléments commutables (51 à 58) pouvant relier ledit noeud commun à l'un desdits premier et second noeuds de commutateur dans chacune desdites phases.

13. Circuits de commutation selon la revendication 12, dans lesquels le nombre d'éléments commutables qui changent d'état d'une phase à l'autre est constant.

14. Convertisseur numérique/analogique qui comprend des circuits de commutation selon l'une quelconque des revendications 11 à 13.

15. Puce de circuit intégré ou chipset qui comprend des circuits d'entraînement de commutateur selon l'une quelconque des revendications 1 à 10, ou qui comprend des circuits de commutation selon l'une quelconque des revendications 11 à 13, ou qui comprend un convertisseur numérique/analogique selon la revendication 14.

16. Carte de circuit imprimé qui comprend des circuits d'entraînement de commutateur selon l'une quelconque des revendications 1 à 10, ou qui comprend des circuits de commutation selon l'une quelconque des revendications 11 à 13, ou qui comprend un convertisseur numérique/analogique selon la revendication 14.

17. Emetteur RF qui comprend un convertisseur numérique/analogique selon la revendication 14.

18. Station de base, station de relais ou dispositif mobile qui comprend un émetteur RF selon la revendication 17.
